(19) Europäisches Patentamt
European Patent Office
Office européen des brevets

(11) **EP 4 333 087 A1**

(12) **EUROPEAN PATENT APPLICATION**
published in accordance with Art. 153(4) EPC

(43) Date of publication:
**06.03.2024 Bulletin 2024/10**

(21) Application number: **22795625.7**

(22) Date of filing: **19.04.2022**

(51) International Patent Classification (IPC):
**H01L 41/257** (2013.01)      **H02N 2/12** (2006.01)

(52) Cooperative Patent Classification (CPC):
**G02B 7/04; H02N 2/12; H10N 30/045; H10N 30/06;
H10N 30/20; H10N 30/853; H10N 30/88**

(86) International application number:
**PCT/JP2022/018116**

(87) International publication number:
**WO 2022/230712 (03.11.2022 Gazette 2022/44)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(30) Priority: **27.04.2021 JP 2021074969**

(71) Applicant: **CANON KABUSHIKI KAISHA
Tokyo 146-8501 (JP)**

(72) Inventors:
• **WATANABE, Takayuki
Tokyo 146-8501 (JP)**
• **UEBAYASHI, Akira
Tokyo 146-8501 (JP)**

(74) Representative: **Canon Europe Limited
European Intellectual Property Group
4 Roundwood Avenue
Stockley Park
Uxbridge UB11 1AF (GB)**

(54) **VIBRATION ACTUATOR, OPTICAL DEVICE, AND ELECTRONIC DEVICE**

(57)     An elastic body and a piezoelectric material are bonded to each other by a conductive bonding portion in which conductive particles are dispersed.

# FIG. 1F

## Description

Technical Field

The present invention relates to a vibration actuator including an ultrasonic motor.

Background Art

A vibration actuator includes a vibrator that is configured such that vibration is excited in an elastic body bonded to the piezoelectric element by applying an alternating-current voltage to an electric-mechanical energy conversion element, such as a piezoelectric element. A vibration actuator is used as an ultrasonic motor that causes a vibrator and a contact body that is in pressure contact with the vibrator to move relative to each other by using a driving force of vibration excited in the vibrator.

PTL 1 discloses a method of manufacturing a vibrator that is used in a vibration actuator. PTL 1 discloses, in an embodiment described therein, a step of performing poling on a piezoelectric ceramic while using a vibrating plate as a ground after the vibrating plate and a power supply member have been bonded to a piezoelectric element.

Citation List

Patent Literature

PTL 1: Japanese Patent Laid-Open No. 2017-184233

Summary of Invention

Technical Problem

However, in the step described in PTL 1, there is a problem in that a poling failure occurs due to insufficient electrical contact between the piezoelectric element and the elastic body, which in turn results in the malfunction of the vibration-type actuator malfunctions.

Solution to Problem

In order to solve the above problem, a vibration actuator of the present invention includes

a vibrator in which an electrode, a piezoelectric material, and an elastic body are sequentially arranged, and
a contact body that is disposed so as to be in contact with the elastic body and so as to be movable relative to the vibrator.

The elastic body and the piezoelectric material are bonded to each other by a conductive bonding portion.
Advantageous Effects of Invention
According to the present invention, a vibration actuator in which a poling failure that leads to unfavorable characteristics does not occur can be provided.

Brief Description of Drawings

[Fig. 1A] Fig. 1A is a side view illustrating a schematic structure of a vibration actuator of the present invention that uses an annular piezoelectric material or a rectangular piezoelectric material.
[Fig. 1B] Fig. 1B is a perspective view illustrating the schematic structure of the vibration actuator of the present invention that uses the annular piezoelectric material or the rectangular piezoelectric material.
[Fig. 1C] Fig. 1C is a rear view illustrating the schematic structure of the vibration actuator of the present invention that uses the annular piezoelectric material or the rectangular piezoelectric material.
[Fig. 1D] Fig. 1D is a side view illustrating the schematic structure of the vibration actuator of the present invention that uses the annular piezoelectric material or the rectangular piezoelectric material.
[Fig. 1E] Fig. 1E is a perspective view illustrating the schematic structure of the vibration actuator of the present invention that uses the annular piezoelectric material or the rectangular piezoelectric material.

[Fig. 1F] Fig. 1F is a rear view illustrating the schematic structure of the vibration actuator of the present invention that uses the annular piezoelectric material or the rectangular piezoelectric material.

[Fig. 2A] Fig. 2A is a diagram illustrating a vibration mode A that is one of two vibration modes generated by a vibrator of the present invention that includes a rectangular piezoelectric material.

[Fig. 2B] Fig. 2B is a diagram illustrating a vibration mode B that is the other of the two vibration modes generated by the vibrator of the present invention that includes the rectangular piezoelectric material.

[Fig. 3A] Fig. 3A is a diagram illustrating a schematic structure of a rectangular piezoelectric material provided with first, second, and third electrodes.

[Fig. 3B] Fig. 3B is a diagram illustrating the schematic structure of the rectangular piezoelectric material provided with the first, second, and third electrodes.

[Fig. 4A] Fig. 4A is a diagram illustrating a schematic structure of a rectangular piezoelectric material provided with first, second, third, and fourth electrodes.

[Fig. 4B] Fig. 4B is a diagram illustrating the schematic structure of the rectangular piezoelectric material provided with the first, second, third, and the fourth electrodes.

[Fig. 5] Fig. 5 is a diagram illustrating a schematic structure of an optical device of the present invention.

Description of Embodiments

A vibration actuator of the present invention includes a vibrator in which an electrode, a piezoelectric material, and an elastic body are sequentially arranged and a contact body that is disposed so as to be in contact with the elastic body and so as to be movable relative to the vibrator. The elastic body and the piezoelectric material are bonded to each other by a conductive bonding portion.

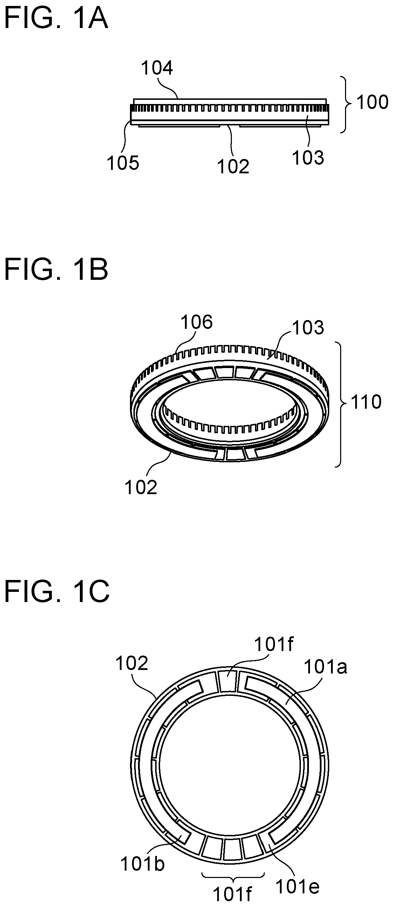

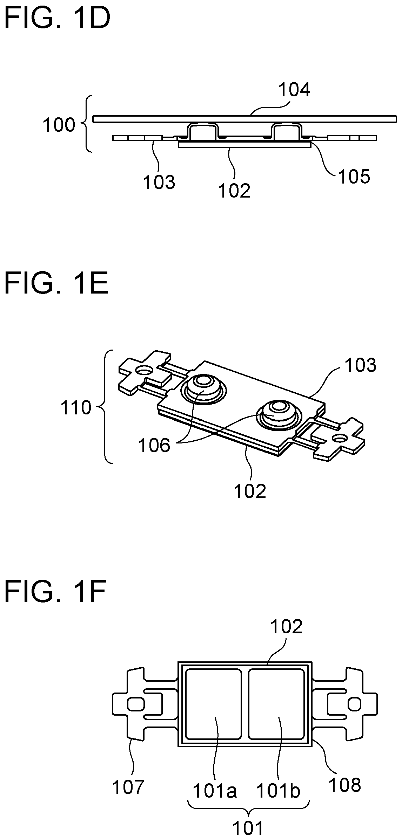

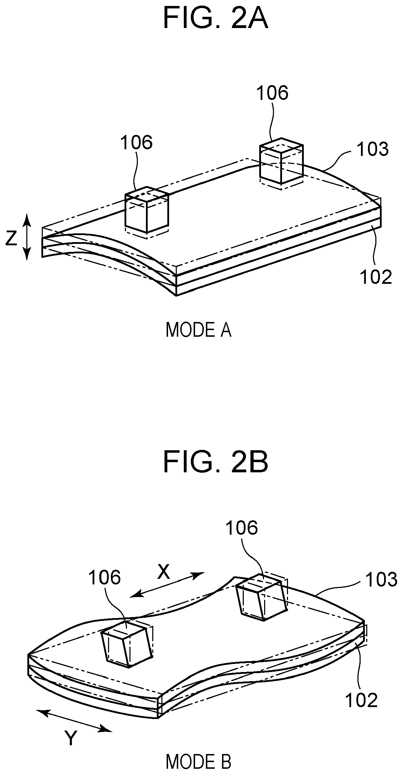

Fig. 1A to Fig. 1F, Fig. 2A, and Fig. 2B illustrate schematic structures of the vibration actuator of the present invention. An annular piezoelectric material and a rectangular piezoelectric material are used in the vibration actuators illustrated in Fig. 1A to Fig. 1F, Fig. 2A, and Fig. 2B.

A vibration actuator 100 of the present invention includes a vibrator 102 in which an electrode 101, a piezoelectric material 102, and an elastic body 103 are sequentially provided and a contact body 104 that is in contact with the elastic body 103, and the elastic body 103 and the piezoelectric material 102 are bonded to each other by a conductive bonding portion 105.

The elastic body 103 includes projecting portions 106, and the projecting portions 106 are configured to be in pressure contact with the contact body 104.

The contact body 104 is not limited to being a member that is brought into direct contact with the vibrator 110 and may be a member that is brought into indirect contact with the vibrator 110 with another member interposed therebetween as long as the contact body 104 is a member that is movable relative to the vibrator 110.

(Electrode)

In the case of using an annular piezoelectric material, the piezoelectric material is provided with the electrode 101 that is divided in a circumferential direction. The electrode 101 includes driving-phase electrodes 101e and non-driving phase electrodes 101f. The length of each of the driving-phase electrodes in the circumferential direction is 1/2 of a wavelength $\lambda$ of a drive frequency. The length of each of the non-driving phase electrodes (ground electrodes, monitor electrodes) in the circumferential direction is 1/4 of the wavelength $\lambda$ of the drive frequency. The number of the driving-phase electrodes and the number of the non-driving phase electrodes vary in accordance with the number of progressive waves that are excited in the annular piezoelectric material. The piezoelectric material corresponding to each of the driving-phase electrodes is subjected to poling with a voltage having a polarity different from that of an adjacent region.

The driving-phase electrodes are isolated from each other by an odd number of non-driving phase electrodes. After the poling, a first electrode 101a and a second electrode 101b are provided in such a manner that two driving-phase electrode groups that are isolated from each other by the non-driving phase electrodes are shortcircuited. The first electrode 101a and the second electrode 101b are used for driving the vibration actuator that uses the annular piezoelectric material.

In the case of using a rectangular piezoelectric material, the electrode 101 that has a rectangular shape is provided. The electrode 101 includes the first electrode 101a and the second electrode 101b. The first electrode 101a and the second electrode 101b are used for performing poling of the rectangular piezoelectric material and for driving the vibration actuator that uses the rectangular piezoelectric material.

The electrode is formed of a metal film having a thickness of about 0.3 um to about 10 um. Although the material of the electrode is not particularly limited, a silver, gold, or platinum electrode is generally used. The method of manufacturing the electrode is not limited, and the electrode can be formed by, for example, screen printing, a sputtering method, or a vacuum deposition method. When it is desired to remove lead from the piezoelectric element, a paste or a target having a lead content of less than 1,000 ppm is used for formation of the electrode.

(Piezoelectric Material)

The piezoelectric material 102 includes a piezoelectric ceramic (a sintered compact) having no crystal orientation, a crystal-oriented ceramic, and a piezoelectric single crystal. The piezoelectric material may be a multilayer body of an inner-layer electrode and a piezoelectric material or may be a single plate of a piezoelectric material. A single plate is advantageous from the standpoint of the manufacturing costs of the piezoelectric material. In order to drive a vibration-wave actuator, the piezoelectric material is subjected to poling. When the frequency of an alternating-current electric field applied to the piezoelectric material, which has undergone poling, comes close to the resonant frequency of the piezoelectric material, the piezoelectric material vibrates to a large extent due to resonance.

(Elastic Body)

It is preferable that the elastic body 103 be made of a metal from the standpoint of properties as an elastic body and processability. Examples of a metal that can be used for the elastic body 103 include aluminum, a brass, and a stainless steel. Among stainless steels, martensitic stainless steel is preferable, and SUS420J2 is most preferable. The elastic body includes the projecting portions 106 that are in contact with the contact body. The elastic body is quenched, plated, or nitrided in order to improve the wear resistance of the projecting portions.

(Conductive Bonding Portion)

The elastic body 103 and the piezoelectric material 102 are bonded to each other by the conductive bonding portion 105. The conductive bonding portion of the present invention is a mixture of conductive particles and a non-conductive bonding portion. The conductive particles are sandwiched between to-be-bonded bodies, so that the to-be-bonded bodies are electrically connected to each other.

A resin (acrylic, styrene, or the like) coated with a metal such as gold, nickel, or silver is used for the conductive particles. The volume resistivity of each of the conductive particles is less than 0.01 Qcm. Although the shape of each of the conductive particles is not limited, it is typically a spherical shape. A protrusion may be provided on a metal coating layer, which is the outermost surface, in order to improve engagement with the to-be-bonded bodies.

The conductive particles not only electrically connect the to-be-bonded bodies to each other, but also function as a gap material that keep the thickness of a bonding layer constant. The to-be-bonded bodies (such as the elastic body, the piezoelectric material, and the electrode provided on the piezoelectric material) each have a surface roughness determined by a processing method or a forming method, and thus, the conductive particles does not function as a gap material when they are excessively small. On the other hand, when the conductive particles are excessively large, the thickness of the bonding layer becomes excessively large, and the vibration generated by the piezoelectric material is attenuated, which in turn results in degradation of the performance of the vibration actuator. It is extremely difficult to obtain conductive particles each having a diameter of less than 2 microns, and conductive particles that are commonly available each have a diameter of about 2 microns to about 30 microns. The distribution of the diameters of the conductive particles is expressed by a CV value.

There is an optimal range of modulus of elasticity for the conductive particles to function as a gap material. When the modulus of elasticity of the conductive particles is too low, plastic deformation is caused by the pressure for pressure-bonding the to-be-bonded bodies to each other, and the conductive particles do not function as a gap material. When the modulus of elasticity of the conductive particles is too high, although the probability that plastic deformation will be caused by the pressure for pressure-bonding the to-be-bonded bodies to each other is reduced, the contact area between the conductive particles and the to-be-bonded bodies is small, and the reliability of electrical connection remains moderate When the conductive particles are crushed in the range of elastic deformation between the to-be-bonded bodies, the contact area between the conductive particles and the to-be-bonded bodies increases, and the reliability of the electrical connection increases, which is preferable.

In the case where an adhesive containing no conductive particles is used, the to-be-bonded bodies are brought into direct contact with each other. In other words, the amount of the adhesive remaining between the elastic body and the piezoelectric material is significantly reduced, and the bonding strength is reduced. When the bonding strength is low, the elastic body and the piezoelectric material become separated from each other while the vibration actuator is driven, and this causes a malfunction.

In addition, when attempting to perform poling by applying a voltage to the piezoelectric material via the elastic body after the elastic body and the piezoelectric material have been bonded to each other, a poling failure occurs because the amount of the adhesive remaining between the elastic body and the piezoelectric material is not uniform. In the event of a poling failure, the piezoelectric performance of the piezoelectric material degrades, resulting in the performance of the vibration actuator falling short of the specifications. In other words, in the case where the conductive bonding portion is not used, there is a certain probability of a decrease in the bonding strength and occurrence of a poling failure, resulting in a reduction in the non-defective rate.

When the conductive particles located between the elastic body and the piezoelectric material come into contact with both the elastic body and the piezoelectric material simultaneously, so that the elastic body and the piezoelectric material are electrically connected to each other. In other words, by applying a voltage between the electrode provided on the piezoelectric material and the elastic body, poling can be reliably performed on the piezoelectric material.

When poling is performed, for example, the elastic body is grounded, and a voltage is applied to the electrode provided on the piezoelectric material. When a power supply member is bonded to the electrode, a portion of the electrode is not covered with the power supply member and is left exposed. When poling is performed after the step of bonding the power supply member, a voltage is applied between the electrode and the elastic body by bringing an external electrode (e.g., a metal pin) into contact with the exposed portion. Conversely, a voltage may be applied to the elastic body, and the electrode provided on the piezoelectric material may be grounded. In any case, in this voltage application method, a power supply member is not used for poling.

In the case where power supply members have sufficient electrical pressure resistance, it is possible to connect the power supply members to a power source one by one and perform poling on the piezoelectric material. However, the work efficiency is low. In addition, the shape of a power supply member is often changed in accordance with the specifications (stroke and so forth) of the vibration actuator. Thus, it is also difficult to automate connection between an electrode terminal of a power supply member and a power source. Consequently, a poling method in which a voltage is applied to a piezoelectric material without using a power supply member is preferable.

Although the type of the adhesive is not particularly limited, an epoxy resin that has high strength, short curing time, high resistance to environmental changes (temperature changes, high humidity, and so forth) is preferable.

In the case where poling is performed after the elastic body and the power supply member have been bonded to the piezoelectric material, it is preferable that the glass transition temperature (Tg) of the adhesive be higher than the temperature at which the poling is performed by 20°C or more so as to prevent the bonded members from moving or becoming separated at the temperature at which the poling is performed. Given that the poling is performed at a temperature of approximately 80°C or higher, it is preferable that the Tg of the adhesive be 100°C or higher. It is more preferable that the Tg be 120°C or higher because, in this case, the temperature at which the poling is performed can be further increased by 20°C, and the poling time can be shortened, or the voltage intensity can be set to be low.

In order to transmit the vibration generated by the piezoelectric material to the elastic body without attenuating the vibration as much as possible, it is preferable that the epoxy resin have a modulus of elasticity of 1 GPa or more. It is more preferable that the epoxy resin have a modulus of elasticity of 2 GPa or more because, in this case, attenuation can be further suppressed. In addition, shear strain occurs in the adhesive due to the difference in thermal expansion coefficient between the elastic body and the piezoelectric material during cooling from the curing temperature of the adhesive to a room temperature. It is preferable that the shear strength of the adhesive be 10 MPa or more in order that the elastic body and the piezoelectric material are kept bonded to each other without becoming separated from each other even when shear strain occurs. It is more preferable that the shear strength of the adhesive be 20 MPa or more because, in this case, a higher curing temperature can be selected, and the curing time of the adhesive can be shortened. The shear strength of the adhesive can be measured on the basis of JIS Standard (JIS6850).

(Contact Body)

It is preferable that the contact body 104 be made of a stainless steel from the standpoint of rigidity. Among stainless steels, martensitic stainless steel is preferable, and SUS420J2 is most preferable. Since the contact body 104 is brought into frictional contact with the elastic body 103, the contact body 104 needs to have high wear resistance, and the surface of the contact body 104 is subjected to a nitriding treatment or an alumite treatment. A frictional force acts between the projecting portions 106 and the contact body 104 due to their pressure contact. The vibration generated by the piezoelectric material 102 causes elliptic vibration of an end portion of each of the projecting portions 106, and a driving force (thrust) that drives the contact body 104 can be generated. The contact body is generally called a slider or a rotor.

(Vibration Actuator using Annular Piezoelectric Material)

In an annular piezoelectric element, the piezoelectric material that is in contact with adjacent driving-phase electrodes is polarized with different polarities. Thus, when an electric field of the same polarity is applied to the driving-phase electrodes 101e, the expansion and contraction polarities of the piezoelectric material in the region are alternately reversed at a $\lambda/2$ pitch. When an alternating-current voltage is applied to the first electrode 101a, a first standing wave with the wavelength λ is generated along the whole periphery of the vibrator. When an alternating-current voltage is applied to the second electrode 101b, although a second standing wave is generated in a similar manner, the position of the wave is rotationally moved by λ/4 in the circumferential direction with respect to the first standing wave. In contrast, two types of alternating-current voltages having the same frequency and a temporal phase difference of n/2 are applied to the first and second electrodes. As a result of combination of the first and second standing waves, a progressive wave (with a wave number n and the wavelength λ along the annular shape) of bending vibration (vibration whose amplitude is perpendicular to a surface of the vibrator) that travels in the circumferential direction is generated along the whole periphery of the vibrator.

When a progressive wave of bending vibration (hereinafter sometimes simply referred to as "bending vibration wave") is generated, each point on a surface of a vibrating plate included in the vibrator performs an elliptic motion, and thus, a movable body that is in contact with this surface receives a frictional force (a driving force) in the circumferential direction from the vibrating plate so as to rotate. The direction of rotation of the movable body can be reversed by switching the polarity of the phase difference between the alternating-current voltages applied to the first and second electrodes. In addition, the speed at which the movable body rotates can be controlled the frequencies or the amplitudes of the alternating-current voltages applied to the first and second electrodes.

(Vibration Mode)

In the vibration actuator of the present invention,

it is preferable that the piezoelectric material have a rectangular shape,
it is preferable that the electrode include a first electrode and a second electrode that are adjacent to each other, and
it is preferable that, when a region of the piezoelectric material in which the first electrode is disposed and a region of the piezoelectric material in which the second electrode is disposed are respectively defined as a first region and a second region, the vibrator form
a first bending vibration mode in which the first region and the second region extend or contract together and
a second bending vibration mode in which the second region contracts when the first region extends and in which the second region extends when the first region contracts.

Fig. 2A and Fig. 2B illustrate two vibration modes generated by the vibrator of the present invention that includes a rectangular piezoelectric material. The rectangular piezoelectric material is provided with the first electrode 101a and the second electrode 101b, and the region in which the first electrode 101a is provided and the region in which the second electrode 101b is provided will be referred to as a first region and a second region, respectively.

· Mode A

When the first region and the second region extend or contract together, a first bending vibration mode (mode A) is generated. In the mode A, the phase difference between the alternating-current voltages $V_A$ and $V_B$ that are applied to the first electrode 101a and the second electrode 101b is 0°, and when the frequency is near the resonant frequency of the mode A, the mode A is most strongly excited. The mode A is a first out-of-plane vibration mode in which two nodes (points at which the amplitude becomes minimum) approximately parallel to a long side of the vibrator 110 appear. Each of the projecting portions 106 of the elastic body is disposed in the vicinity of a position at which an antinode (a point at which the amplitude becomes maximum) of the mode A. Thus, end surfaces of the projecting portions 106 reciprocate in the Z direction due to the vibration mode A.

· Mode B

When the second region contracts while the first region extends, and when the second region extends while the first region contracts, a second bending vibration mode (mode B) is generated. In the mode B, the phase difference between the alternating-current voltages $V_A$ and $V_B$ that are applied to the first electrode 101a and the second electrode 101b is 180°, and when the frequency is near the resonant frequency of the mode B, the mode B is most strongly excited. The mode B is a second out-of-plane vibration mode in which three nodes approximately parallel to a short side of the vibrator 110 appear. Each of the projecting portions 106 of the elastic body is disposed in the vicinity of a position at which an antinode of the mode B. Thus, the end surfaces of the projecting portions 106 reciprocate in the X direction due to the vibration mode B.

In the vibration actuator 100, the mode A and the mode B are simultaneously excited when the phase difference between the alternating-current voltages $V_A$ and $V_B$ is 0° ± 180°, and elliptic vibration is excited in the projecting portions 106. The vibration actuator that uses the rectangular piezoelectric material and that is driven in the mode A and the mode B is preferable because it can be easily reduced in size.

(Structure 1 of Elastic Body)

It is preferable that the elastic body 103 include a rectangular portion 108 to which the rectangular piezoelectric material is bonded by the conductive bonding portion and that the vibrator be held at four corners of the rectangular portion by a vibrator holding member. A projecting portion may be provided inside the rectangular portion. In order to bond the piezoelectric element and the elastic body to each other with a bonding strength sufficient for driving the vibration actuator, it is necessary to increase the bonding area as much as possible. On the other hand, if the elastic body includes an unnecessary portion that is not bonded to the piezoelectric element, there is a possibility that the unnecessary portion may cause vibration other than the mode A and the mode B, resulting in a decrease in the efficiency of the vibration actuator. Considering misalignment in bonding, it is preferable that the rectangular portion 108 be larger than one side of the rectangular piezoelectric material by 0.1 mm to 0.6 mm.

(Structure 2 of Elastic Body)

It is preferable that the elastic body 103 include a support portion 107 that protrudes from an end portion of the rectangular portion 108. The vibrator 110 can be held by, for example, providing a fitting portion on the support portion. By designing an ingenious shape of the support portion extending from the rectangular portion and providing the fitting portion at a position in the support portion, the position being near a node of vibration, vibration of the vibrator can be prevented from being interfered with while the vibrator is held by the support portion.

(Electrode Arrangement 1)

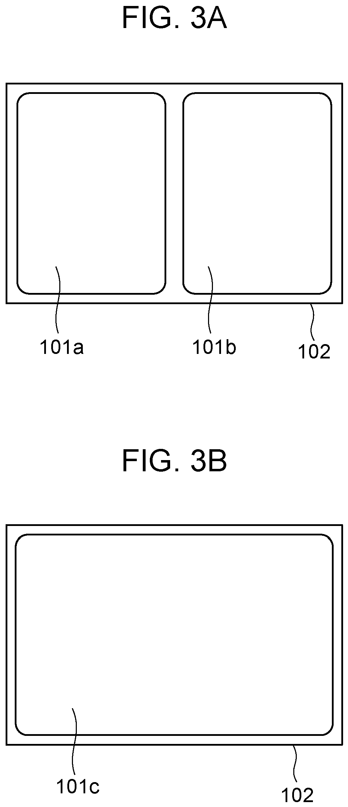

It is preferable that the vibration actuator of the present invention include a third electrode that sandwiches the piezoelectric material together with the first and second electrodes.
The rectangular piezoelectric material illustrated in Fig. 3A and Fig. 3B includes a third electrode 101c that sandwiches the piezoelectric material 102 together with the first and second electrodes 101a and 101b. The elastic body is provided with the projecting portions 106 as illustrated in Fig. 1E. A non-contact portion at which the elastic body and the piezoelectric material are not bonded to each other by the conductive bonding portion is formed directly under the projecting portions 106. In the case of attempting to perform poling by applying a voltage to the piezoelectric material via the elastic body, the voltage is not applied to the piezoelectric material below the non-contact portion without the third electrode. As a result, a portion of the piezoelectric material that is not subjected to poling increases, and the performance of the vibration actuator degrades. Thus, it is preferable to provide the third electrode 101c because, in this case, poling can be performed also on the piezoelectric material below the non-contact portion.

(Electrode Arrangement 2)

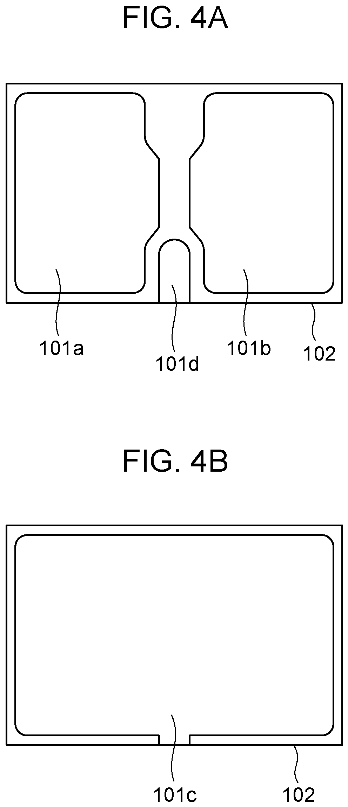

It is preferable that the vibration actuator of the present invention further include a fourth electrode that is adjacent to the first and second electrodes and that is electrically connected to the third electrode.
The rectangular piezoelectric material illustrated in Fig. 4A and Fig. 4B includes, in addition to the first electrode 101a, the second electrode 101b, and the third electrode 101c, a fourth electrode 101d that is adjacent to the first and second electrodes 101a and 101b and that is electrically connected to the third electrode 101c. In Fig. 6, as a method of electrically connecting the third electrode 101c and the fourth electrode 101d to each other, a configuration is illustrated as an example in which the third electrode 101c and the fourth electrode 101d are connected to each other via a side surface of a piezoelectric material 107. Alternatively, the third electrode and the fourth electrode may be connected to each other without passing through the side surface of a piezoelectric material by, for example, forming a through hole extending through the piezoelectric material 107 and wiring an electrode material into the through hole. It is preferable that the diameter of the through hole be less than 200 microns so as not to interfere with vibration of the piezoelectric material. In the case where the fourth electrode is formed on the piezoelectric material, the first electrode, the second electrode, and the fourth electrode are formed on the same surface of the piezoelectric material. In other words, the shape of the power supply member can have a planar simple structure. Even in the case where the third electrode is covered with the elastic body, a voltage for driving can be applied to the third electrode via the fourth electrode, which is electrically connected to the third electrode.

(Thickness of Adhesive)

It is preferable that the conductive bonding portion of the vibration actuator of the present invention have a thickness of 1.5 microns or more and 7 microns or less.

When the thickness of the conductive bonding portion is larger than 7 microns, the vibration generated by the piezoelectric material is absorbed by the conductive bonding portion, resulting in poor performance of the vibration actuator.

When the thickness of the conductive bonding portion is smaller than 1.5 microns, the amount of the adhesive between the piezoelectric material and the elastic body is small, and there is a possibility that the elastic body will become separated while the vibration actuator is driven. Thus, it is preferable that the average thickness of the conductive bonding portion be 1.5 microns or more and 7 microns or less.

The thickness of the conductive bonding portion refers to the average thickness of the conductive bonding portion that is determined by the following evaluation method. The average thickness of the conductive bonding portion can be determined by observing a cross-section of a surface including the piezoelectric element, the conductive bonding portion, and the elastic body. An electron microscope can be used to observe the cross-section. For example, the cross-section of the conductive bonding portion is observed from a direction perpendicular to the direction in which the piezoelectric material, the conductive bonding portion, and the elastic body are stacked on top of one another. An appropriate observation magnification is about 500 times. The cross-sectional area of the conductive bonding portion is calculated from an observed image. The average thickness of the conductive bonding portion is calculated by dividing the obtained cross-sectional area by the horizontal width of the observed region, that is, the length of the conductive bonding portion in the horizontal direction.

(Dimension and Volume Density of Conductive Particles)

It is preferable that the conductive bonding portion include conductive particles whose average particle diameter is 2 microns or more and 5 microns or less with a volume fraction of 0.4% or more and 2% or less.

The distance between the piezoelectric element and the elastic body can be controlled by making the sizes of the conductive particles included in the conductive bonding portion uniform. The distribution of particle size can be represented by a CV value (Coefficient of Variation, CV (%) = standard deviation of particle diameters / average of particle diameters $\times$ 100). When the CV value is large, the percentage of conductive particles each having a diameter larger than the average particle diameter increases, and the thickness of the conductive bonding portion becomes larger than the average particle diameter. When the particle sizes are made uniform, the CV value is less than 10%. It is preferable that the CV value be 6% or less because, in this case, the uniformity of the thickness of the conductive bonding portion increases.

The conductive particles whose average particle diameter is less than 2 microns may sometimes become embedded within the surface irregularities of the piezoelectric material, the elastic body, and the electrode, and their advantageous effects as a gap material may sometimes not be obtained. The surface irregularities of the piezoelectric material, the elastic body, and the electrode increase or decrease depending on scratches generated by lapping or the degree of grain growth during firing or baking of the piezoelectric material or an electrode material.

It is not preferable that the average particle diameter of the conductive particles be larger than 5 microns because, in this case, the thickness of the conductive bonding portion becomes larger than 7 microns, and the efficiency of the vibration actuator decreases. The average particle diameter of the conductive particles is determined by observing the conductive bonding portion located between the elastic body and the piezoelectric material and by calculating the average of the diameters of at least three or more particles.

When the volume fraction of the conductive particles in the conductive bonding portion is less than 0.4%, pressure is concentrated at the conductive particles when the elastic body and the piezoelectric material are bonded to each other, and the conductive particles become crushed. When the conductive particles are crushed, the thickness of the conductive bonding portion cannot be controlled, and the bonding strength becomes insufficient. Alternatively, since the number of the conductive particles is small, the resistance between the elastic body and the piezoelectric material becomes high, and a poling failure occurs, resulting in poor performance of the vibration actuator.

When the volume fraction of the conductive particles in the conductive bonding portion is greater than 2%, although the reliability of the electrical connection between the elastic body and the piezoelectric element increases, the bonding area decreases, and thus, the bonding strength between the piezoelectric material and the elastic body is reduced.

Thus, when the conductive bonding portion includes conductive particles whose average particle diameter is 2 microns or more and 5 microns or less with a volume fraction of 0.4% or more and 2% or less, both of high bonding strength and electrical connection between the elastic body and the piezoelectric material can be achieved. When there is electrical connection, the electric resistance between the fourth electrode and the elastic body is less than 10 Q. Calculation of the volume fraction can be calculated with the area ratio between the bonding layer and the particles by substituting the cross-sectional areas of an adhesive portion and a conductive particle portion that are included in the conductive bonding portion by using the result of observation of the cross-section of the conductive bonding portion, which has been mentioned above.

(Density of Conductive Particles)

It is preferable that the specific gravity of the conductive particles be 2.0 $g/cm^3$ or more and 4.0 $g/cm^3$ or less. The specific gravity of the conductive particles changes in accordance with the volume fraction of a metal layer having high specific gravity and resin balls having low specific gravity.

When the specific gravity of the conductive particles is less than 2.0 $g/cm^3$, the proportion of metal in the conductive particles is low, and favorable conductivity between the elastic body and the electrode cannot be obtained. In addition, the conductive particles may easily become crushed when the piezoelectric material and the elastic body are bonded to each other.

When the specific gravity of the conductive particles is greater than 4.0 $g/cm^3$, the difference in specific gravity between the conductive particles and the adhesive is large, leading to precipitation of the conductive particles in the adhesive. When precipitation of the conductive particles in the adhesive occurs, the amount of the conductive particles included in the conductive bonding portion may vary with each application of the adhesive to a portion to be bonded.

Thus, it is preferable that the specific gravity of the conductive particles be 2.0 $g/cm^3$ or more and 4.0 $g/cm^3$ or less. In the case where actual measurement of the specific gravity of the conductive particles cannot be performed, calculation of the specific gravity can be performed by using the structure of the conductive particles and the specific gravities of the constituent materials.

(Anisotropy of Conductive Bonding Portion)

It is preferable that the conductive bonding portion be made of an anisotropic conductive material.

There is a case where the conductive bonding portion projects from the portion to be bonded when a bonding operation is performed and adheres to the side surface of the piezoelectric material. When the conductive bonding portion is made of an anisotropic conductive material, even if the conductive bonding portion projects and comes into contact with the first electrode or the second electrode via the side surface of the piezoelectric material, an electrical short-circuit between the first or second electrode and the elastic body can be prevented from occurring. When the conductive bonding portion is made of an anisotropic conductive material, the surface resistance of the conductive bonding portion, which projects from a portion to be bonded between the piezoelectric element and the elastic body, the surface resistance being measured by placing a tester with a gap of 2 mm or more formed between a surface of the conductive bonding portion and the tester, is greater than 10 Q.

(Composition 1 of Piezoelectric Material)

It is preferable that the piezoelectric material have a lead content of less than 1,000 ppm. In particular, it is preferable that the main component of the piezoelectric material be a barium titanate-based component.

From the standpoint of high piezoelectric constant and relative ease of manufacturing, it is preferable that the piezoelectric material be made of a barium titanate-based material. Here, examples of the barium titanate-based material include barium titanate ($BaTiO_3$), barium calcium titanate ($(Ba, Ca)TiO_3$), and barium zirconate titanate ($Ba(Ti, Zr)O_3$). Another example of the barium titanate-based material is barium calcium zirconate titanate ($(Ba, Ca)(Ti, Zr)O_3$). Other examples of the barium titanate-based material include compositions such as sodium niobate-barium titanate ($NaNbO_3$-$BaTiO_3$), bismuth sodium titanate-barium titanate, bismuth potassium titanate-barium titanate, and materials containing these compositions as main components. In particular, from the standpoint of being capable of achieving both the piezoelectric constant and mechanical quality factor of a piezoelectric ceramic, the following materials are preferable. In other words, it is preferable to contain barium calcium zirconate titanate ($(Ba, Ca)(Ti, Zr)O_3$) or sodium niobate-barium titanate ($NaNbO_3$-$BaTiO_3$) as a main component. It is preferable to contain manganese or bismuth as an element other than a main component. The term "main component" refers to a component of a material whose weight fraction is greater than 10%.

It is more preferable that the piezoelectric material have a lead content of 1,000 ppm or less because, in this case, the environmental load is low. In general, lead zirconate titanate ($Pb(Zr, Ti)O_3$), which contains lead, is widely used for piezoelectric devices. Thus, it has been pointed out that, if a piezoelectric element is, for example, discarded and exposed to acid rain or is left in a harsh environment, there is a possibility that a lead component in piezoelectric ceramics of the related art may dissolve into the soil and damage the ecosystem. Accordingly, it is preferable that the piezoelectric material of the present invention be a barium titanate-based piezoelectric material having a lead content of less than 1,000 ppm. The content of lead can be measured by, for example, ICP emission spectrochemical analysis.

(Composition 2 of Piezoelectric Material)

It is preferable that the main component of the piezoelectric material be barium calcium zirconate titanate (hereinafter referred to as BCTZ). When BCTZ is the main component, the piezoelectric properties of BCTZ can be adjusted depending on the application by adjusting the amount of Ca or Zr. In addition, the amount of niobium, which is expensive, used can be reduced.

(Composition 3 of Piezoelectric Material)

It is preferable that the piezoelectric material be a piezoelectric material that includes an oxide having a perovskite structure containing Ba, Ca, Ti, and Zr and that includes Mn.

It is preferable to satisfy the following: when the molar ratio of Ca to the sum of Ba and Ca is x, $0.02 \leq x \leq 0.30$, when the molar ratio of Zr to the sum of Ti and Zr is y, $0.020 \leq y \leq 0.095$, and $y \leq x$.

It is preferable to satisfy the following: when the ratio of the molar quantity of Ba and Ca to the molar quantity of Ti and Zr is $\alpha$, $0.9955 \leq \alpha \leq 1.01$, and the content of Mn with respect to 100 parts by weight of the oxide is 0.02 parts by weight or more and 1.0 parts by weight or less in terms of metal.

Such a piezoelectric material can be expressed by a general formula (1) below.

$$(Ba_{1-x}Ca_x)_\alpha (Ti_{1-y}Zr_y) O_3 \qquad (1)$$

It is preferable that the piezoelectric material have, as a main component, a perovskite-type metal oxide that can be expressed as below.

$$0.986 \leq \alpha \leq 1.100,$$

$$0.02 \leq x \leq 0.30,$$

and

$$0.02 \leq y \leq 0.095.$$

It is preferable that the content of metal components other than the main component contained in the piezoelectric ceramic with respect to 100 parts by weight of the oxide be 1 part by weight or less in terms of metal.

In particular, it is preferable that the metal oxide contain Mn and that the Mn content with respect to 100 parts by weight of the oxide be 0.02 parts by weight or more and 0.40 parts by weight or less in terms of metal. When the Mn content is within the above range, an insulating property or a mechanical quality factor Qm is improved. Here the mechanical quality factor Qm is a factor representing an elastic loss caused by vibration when the piezoelectric material is evaluated as a vibrator, and the magnitude of the mechanical quality factor is observed as the sharpness of a resonance curve in impedance measurement. In other words, it is a constant representing the sharpness of resonance. When the mechanical quality factor Qm is large, the amount of distortion of the piezoelectric material in the vicinity of the resonant frequency becomes larger, and this can effectively cause the piezoelectric material to vibrate.

The general formula (1) implies that, in the metal oxide expressed by the general formula (1), metal elements located at the A-site of the perovskite structure are Ba and Ca, and metal elements located at the B-site of the perovskite structure are Ti and Zr. However, some of Ba and Ca may be located at the B-site. Similarly, some of Ti and Zr may be located at the A-site.

Although the molar ratio between an element at the B-site and the O element in the general formula (1) is 1:3, even if the molar ratio is slightly different, the piezoelectric material is also within the scope of the present invention as long as the metal oxide has a perovskite structure as the main phase.

Whether the metal oxide has a perovskite structure can be determined by, for example, a structural analysis using X-ray diffraction or electron diffraction.

In the general formula (1), x, which denotes the molar ratio of Ca in the A-site, is within the range of $0.02 \leq x \leq 0.30$. When some of Ba of a perovskite-type barium titanate are replaced with Ca within the above range, the phase transition temperature between orthorhombic crystal and tetragonal crystal is shifted toward the low-temperature side, and thus, a stable piezoelectric vibration can be obtained in a driving temperature range of the vibration actuator. However, if x is greater than 0.30, there is a possibility that the piezoelectric constant of the piezoelectric material will become insufficient, resulting in insufficient performance of the vibration actuator. In contrast, if x is less than 0.02, there is a possibility that dielectric loss (tan$\delta$) will increase. If the dielectric loss increases, there is a possibility that the amount of heat generated when the vibration actuator is driven by applying a voltage to the piezoelectric material will increase, which in turn results in a decrease in the efficiency of driving a motor and an increase in consumption of output power.

In the general formula (1), y, which denotes the molar ratio of Zr in the B-site, is within the range of $0.02 \leq x \leq 0.1$. If y is greater than 0.1, Td becomes lower than 80°C, and the temperature range in which the vibration actuator can be used becomes lower than 80°C, which is not favorable.

In the present specification, Td is the lowest temperature among temperatures at which, when the piezoelectric material is heated from a room temperature to Td after one week has elapsed since poling has been performed and then cooled again to a room temperature, the piezoelectric constant is reduced to be smaller than the piezoelectric constant before heating by more than 10%.

In the general formula (1), it is preferable that $\alpha$, which denotes the ratio of the molar quantity of Ba and Ca in the A-site to the molar quantity of Ti and Zr in the B-site, be within a range of $0.9955 \leq \alpha \leq 1.010$. If $\alpha$ is less than 0.9955, abnormal grain growth of crystal grains included in the piezoelectric material may be easily occur, and the mechanical strength of the piezoelectric material decreases. In contrast, if $\alpha$ becomes greater than 1.010, the density of the piezoelectric material does not become high, and the insulating property becomes remarkably brittle.

A method of measuring the composition of the piezoelectric material is not particularly limited. Examples of the method include X-ray fluorescence analysis, ICP emission spectrochemical analysis, and atomic absorption analysis. By any one of these measurement methods, the weight ratio and the composition ratio of each element included in the piezoelectric material can be calculated.

Regarding the Mn content in terms of metal, the contents of metals, which are Ba, Ca, Ti, Zr, and Mn, in the piezoelectric material are calculated by X-ray fluorescence (XRF) analysis, ICP emission spectrochemical analysis, atomic absorption analysis, or the like. By using these contents, the weights of the elements constituting the metal oxide, which is expressed by the general formula (1), are determined in terms of an oxide, and a value that is obtained from the ratio of the weight of Mn to the total weight of the elements, which is regarded as 100, is the Mn content in terms of metal.

If the Mn content is less than 0.02 parts by weight, there is a possibility that the effect of poling necessary for driving the vibration actuator may be insufficient. In contrast, if the Mn content is greater than 0.40 parts by weight, there is a possibility that the piezoelectric characteristics of the piezoelectric material may become insufficient and that a crystal that has a hexagonal crystal structure and that does not have any piezoelectric characteristics may be generated. Mn is not limited to metal Mn and may be included in the piezoelectric material as a Mn component in any form. For example, it may be included in the B-site as a solid solution or may be included in grain boundary. From the standpoint of insulating property or ease of sintering, it is further preferable that the Mn component be included in the B-site as a solid solution.

(Composition 4 of Piezoelectric Material)

It is preferable that the piezoelectric material contain Bi in an amount of 0.042 parts by weight or more and 0.850 parts by weight or less in terms of metal.

The piezoelectric material may contain Bi in an amount of 0.85 parts by weight or less in terms of metal with respect to 100 parts by weight of the metal oxide expressed by the general formula (1). The Bi content with respect to the metal oxide can be measured by, for example, ICP emission spectrochemical analysis. Bi may be present in a grain boundary of the piezoelectric material in a ceramic form or may be included in the perovskite structure of $(Ba, Ca)(Ti, Zr)O_3$. If Bi is present in the grain boundary, friction between particles is reduced, and the mechanical quality factor increases. In contrast, if Bi is included in a solid solution forming the perovskite structure, the phase transition temperature becomes low, and thus, the temperature dependence of the piezoelectric constant decreases, resulting in a further increase in the mechanical quality factor. It is preferable that the position of Bi when Bi is included in a solid solution be in the A-site because, in this case, the charge balance between Bi and Mn is improved.

The piezoelectric material may include components (hereafter referred to as "accessory components") other than the elements included in the general formula (1), Mn, and Bi as long as the characteristics of the piezoelectric material do not change. It is preferable that the sum of the contents of the accessory components be less than 1.2 parts by weight with respect to 100 parts by weight of the metal oxide expressed by the general formula (1). When the content of the accessory components exceeds 1.2 parts by weight, there is a possibility that the piezoelectric characteristics and the insulating characteristics of the piezoelectric material will deteriorate.

(Power Supply Member)

It is preferable that the vibration actuator of the present invention include a power supply member that is bonded to a piezoelectric element including the piezoelectric material and the electrode.

It is preferable to use a flexible printed circuit (hereafter referred to as "FPC") as the power supply member from the standpoint of high dimensional accuracy and ease of positioning. It is preferable that a polyimide be used as the material. Although a method of bonding the FPC and the piezoelectric element to each other is not particularly limited, it is preferable to use an anisotropic conductive paste (ACP) or an anisotropic conductive film (ACF) having high takt time for bonding and high reliability of electrical connection. Power can be supplied without hindering vibration of the piezoelectric element by using the FPC. The FPC is connected at least to the first electrode and the second electrode and may be connected to the fourth electrode.

(Composition of Elastic Body)

It is preferable that the elastic body of the present invention be made of stainless steel SUS420J2 of JIS standard that has previously undergone vacuum quenching. SUS420J2 of JIS standard has low electric resistance (the resistivity thereof at room temperature is 55 $\mu\Omega$cm). By using SUS420J2 for the elastic body, poling can be performed by applying a voltage to the piezoelectric material or the piezoelectric element, which is bonded to the elastic body by the conductive bonding portion, via the elastic body. By quenching SUS420J2 in a vacuum, the strength of SUS420J2 can be increased while preventing formation of an oxide film that increases the electrical resistance. SUS420J2 that has undergone vacuum quenching has high hardness and is suitable for the vibration actuator of the present invention in which the contact body is driven by friction generated between the contact body and the elastic body.

The thickness of the elastic body bonded to the rectangular piezoelectric material is within a range of 0.2 mm to 1.0 mm, and it is preferable that the thickness of the elastic body be within a range of 0.2 mm to 0.35 mm because, in this case, the elastic body has both rigidity and spring property and is easily formed.

(Electronic Device)

An electronic device of the present invention includes the above-described vibration actuator, a member connected to the contact body of the vibration actuator, and a member position detecting unit (e.g., an encoder). The electronic device detects the position of the member and can precisely control the position of the member by causing the vibration actuator to operate until the member is moved to a target position.

(Optical Device)

An optical device of the present invention is an optical device that includes the above-described vibration actuator provided at a driving unit and that further includes at least one of an optical element and an imaging element.

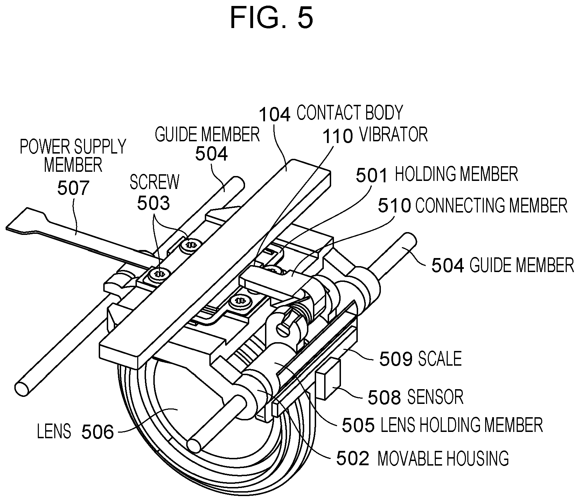

Fig. 5 is a schematic diagram illustrating an embodiment of an optical device (a focusing lens portion of a lens-barrel device) of the present invention. In Fig. 5, the vibrator 110 including the rectangular piezoelectric material is in pressure contact with the contact body (a slider) 104 in a manner similar to that illustrated in Fig. 1D. A power supply member 507 is connected to a surface having the first and second regions. When a desired voltage is applied to the vibrator 110 by a voltage input unit (not illustrated) via the power supply member 507, an elliptic motion occurs at a projecting portion of an elastic body (not illustrated). A holding member 501 is bonded to the vibrator 110 so as to prevent unnecessary vibration from occurring. A movable housing 502 is fixed to the holding member 501 by using screws 503 and integrated with the vibrator 110. These members are included in the electronic device of the present invention. By attaching the movable housing 502 to guide members 504, the electronic device of the present invention becomes capable of moving linearly in two directions (a forward movement direction and a reverse movement direction) along the guide members 504.

A lens 506 (an optical member) that serves as the focusing lens portion of the lens-barrel device will now be described. The lens 506 is fixed to a lens holding member 505 and has an optical axis (not illustrated) that is parallel to a movement direction of the vibration actuator. Similar to the vibration actuator, the lens holding member 505 performs a focal position adjustment (a focusing operation) by moving linearly on the two guide members 504, which will be described below. The two guide members 504 are members that cause the movable housing 502 and the lens holding member 505 to be fitted to each other and enable the movable housing 502 and the lens holding member 505 to move linearly. Such a configuration enables the movable housing 502 and the lens holding member 505 to move linearly on the guide members 504.

A connecting member 510 is a member that transmits a driving force generated by the vibration actuator to the lens holding member 505 and is fitted and attached to the lens holding member 505. As a result, the lens holding member 505 can smoothly move, together with the movable housing 502, in the two directions along the two guide members 504.

A sensor 508 is provided in order to detect the position of the lens holding member 505 on the guide members 504 by reading positional information of a scale 509 that is attached to a side surface portion of the lens holding member 505. The focusing lens portion of the lens-barrel device is fabricated by incorporating the above-described members.

Although a lens-barrel device for a single-lens reflex camera has been described above as an optical device, the type of camera is not limited and may be a compact camera in which a lens and a camera body are integrated together, an electronic still camera, and so forth, and the present invention is applicable to various optical devices provided with vibration actuators.

As another configuration of the vibration actuator, a plurality of vibrators may be in contact with a single common contact body, and the contact body may be disposed so as to be caused by vibrations of the plurality of vibrators to move relative to the plurality of vibrators.

In addition, a conceivable application example of the vibration actuator of the present invention is its application in the medical or engineering fields. More specifically, a wire-driven actuator that includes an elongated member, a wire inserted through the elongated member and fixed to a portion of the elongated member, and the above-described vibration actuator that drives the wire and in which the elongated member is bent as a result of the wire being driven can also be configured.

(Method of Manufacturing Vibrator)

A method of manufacturing a vibrator of the present invention includes

a step of obtaining a piezoelectric element by providing an electrode at an unpolarized piezoelectric material,
a step of bonding the piezoelectric element and an elastic body to each other at a temperature T1 with a conductive bonding portion interposed between the piezoelectric element and the elastic body,
a step of bonding the piezoelectric element and a power supply member to each other at a temperature T2, and
a step of performing poling at a temperature T3 by applying a voltage between the electrode and the elastic body.

The steps are sequentially performed, and the temperatures T1, T2, and T3 satisfy relationships of T1>T3 and T2>T3.

When the conductive bonding portion is used to bond the piezoelectric material and the elastic body to each other, a voltage for poling can be applied to the piezoelectric material via the elastic body while an adhesive is continuously interposed between the piezoelectric element and the elastic body so as to increase the bonding strength. By employing this method, the vibration actuator can be produced with a favorable yield even in the case where the piezoelectric material has a depolarization temperature is lower than a bonding temperature.

If the piezoelectric element and the elastic body are fixed to each other by a non-conductive bonding portion while they are in direct contact with each other, a voltage for poling can be applied to the piezoelectric material via the elastic body. However, when the piezoelectric element and the elastic body are in close contact with each other, the amount of the adhesive held between them is significantly small, and the bonding strength between the piezoelectric element and the elastic body becomes insufficient. If the bonding strength between the elastic body and the piezoelectric element is insufficient, the elastic body becomes separated from the piezoelectric element while the vibration actuator is driven, which in turn results in a failure.

In contrast, in the case where an adhesive is continuously interposed between the piezoelectric element and the elastic body so as to increase the bonding strength instead of bringing the piezoelectric element and the elastic body into direct contact with each other, if the adhesive is non-conductive, a voltage for poling cannot be applied to the piezoelectric material via the elastic body. This is because most of the applied voltage is applied to the non-conductive adhesive.

Thus, in order to perform poling by applying a voltage to the piezoelectric material via the elastic body while maintaining the bonding strength between the elastic body and the piezoelectric material, the elastic body and the piezoelectric material need to be bonded to each other by the conductive bonding portion.

In the method of manufacturing the vibrator of the present invention, it is preferable that, in the poling, an external electrode other than the power supply member be brought into contact with the electrode and that a voltage be applied between the external electrode and the elastic body.

An example of the external electrode is a contact pin included in a poling device that is used for polarizing the vibrator of the present invention. A voltage is applied to the electrode by using the external electrode, and the elastic body is grounded, so that a voltage can be applied to the piezoelectric element without using the power supply member. In this method, the time and effort required to connect a power source for poling to the power supply member can be reduced.

In the method of manufacturing the vibrator of the present invention, it is preferable that the elastic body be made of martensitic stainless steel SUS420J2 of JIS standard that has previously undergone vacuum quenching. By performing vacuum quenching, the strength of the elastic body can be improved without forming a high-resistance oxide film on a surface of the elastic body.

In a method of driving the vibration actuator of the present invention, the vibration actuator includes

a vibrator in which an electrode, a piezoelectric material, and an elastic body are sequentially arranged, and a contact body that is in contact with the elastic body.

The elastic body and the piezoelectric material are bonded to each other by a conductive bonding portion.

The piezoelectric material includes

a first electrode provided in a first region,
a second electrode provided in a second region that is adjacent to the first region,
a third electrode that sandwiches the piezoelectric material together with the first and second electrodes, and
a fourth electrode provided in a third region and electrically connected to the third electrode, the third region being adjacent to the first and second regions.

A voltage is applied between the first electrode and the fourth electrode and between the second electrode and the fourth electrode.

In other words, although a voltage is applied between the first electrode and the elastic body and between the second electrode and the elastic body when the piezoelectric material is subjected to poling, a voltage is applied between the first electrode and the fourth electrode and between the second electrode and the fourth electrode when the vibration actuator is driven. By using different electrodes for poling and driving, the vibration actuator can be produced with a high yield, and the drive voltage can be easily applied to the piezoelectric material.

Examples

Next, the vibration actuator and the vibrator of the present invention will be described by using Examples. However, the present invention is not limited by the following Examples.

Next, the method of manufacturing a piezoelectric vibrator, a method of manufacturing a vibration-wave driving device, and a method of manufacturing an optical device of the present invention will be described by using Examples. However, the present invention is not limited by the following Examples. Note that the Examples will be described with reference to the drawings and by using reference signs illustrated in the drawings.

(Example 1)

The piezoelectric material described in Production Composition 1 of Table 2 was obtained by firing metal oxide powder at a temperature of 1,340°C.

The obtained piezoelectric material was ground approximately uniformly so as to have a thickness of 0.5 mm and polished, and then, the piezoelectric material was processed into an annular shape having an outer diameter of 62 mm and an inner diameter of 54 mm. The driving-phase electrodes 101e and the non-driving phase electrodes 101f illustrated in Fig. 1C were formed on one surface of the shaped piezoelectric material 102. The electrodes were formed by applying a silver paste to the piezoelectric material 102 by screen printing, followed by drying and baking.

Next, the conductive bonding portion 105 was applied to the elastic body 103 made of SUS420J2, and the elastic body 103 was pressure-bonded to the piezoelectric material 102. The annular piezoelectric material and the annular elastic body were arranged by using a positioning jig in such a manner that the centers of their circles coincided with each other. Subsequently, a heat treatment for curing the conductive bonding portion was performed. The piezoelectric material to which the elastic body had been pressure-bonded was heated to a temperature T1 = 160°C, held for 180 seconds, and then cooled to a room temperature, and the pressurization was released, so that a vibrator was obtained. Details of the conductive bonding portion used are shown in Table 1.

Next, an FPC to which an ACP had been applied was thermocompression-bonded to the electrodes provided on the piezoelectric material. The thermocompression bonding was performed under conditions of a temperature of T2 = 140°C and a holding time of 20 seconds. After that, the SUS420J2 serving as the elastic body was grounded, and poling was performed by alternately applying voltages having different polarities to the adjacent driving-phase electrodes 101e. In the poling, a plurality of external electrodes connected to a power supply are brought into contact with an electrode among the driving-phase electrodes 101e and the non-driving phase electrodes 101f, the electrode being used as a sensor. Next, after heating to the T3 = 100°C, an electric field equivalent to 2 kV/mm was applied for 30 minutes. Then, after cooling for 40 minutes to 40°C while applying the electric field, the voltage application was terminated. Subsequently, the first electrode 101a and the second electrode 101b were printed and dried, so that a vibrator was obtained. In the drying step, the temperature of the piezoelectric material is maintained to be lower than 80°C in order to prevent depolarization of the piezoelectric material. The obtained vibrator was brought into pressure contact with a contact body (a rotor) made of SUS420J2, so that a vibration actuator was produced.

(Example 2)

Similar to Example 1, the piezoelectric material described in Production Composition 1 was obtained. The obtained piezoelectric material was ground approximately uniformly so as to have a thickness of 0.35 mm and polished, and then, the piezoelectric material was processed into a rectangular shape having a size of 8.9 mm × 5.7 mm. The first to third electrodes illustrated in Fig. 3A and Fig. 3B were formed on the two surfaces of the shaped piezoelectric material by a method similar to that in Example 1.

Next, a conductive bonding portion was applied to an elastic body made of SUS420J2, and the elastic body was pressure-bonded to the rectangular piezoelectric material. The elastic body used included a rectangular portion having a size of 9.1 mm × 5.8 mm, which is larger than the piezoelectric material, and the thickness of the elastic body was between 0.25 mm to 0.30 mm, inclusive. The rectangular piezoelectric material and the elastic body were arranged by using a positioning jig such that the centers of their rectangular portions coincided with each other and such that the sides of the rectangular portions were parallel to each other. The piezoelectric material was heated to the temperature T1 = 160°C while being pressure-bonded, held for 180 seconds, and then cooled to a room temperature, and the pressurization was released, so that a vibrator was obtained. Details of the conductive bonding portion used are shown in Table 1.

Next, the FPC, to which the ACP had been applied, and the piezoelectric material were pressure-bonded to each other for 20 seconds by using a trowel having a temperature T2 = 140°C, and the FPC was thermocompression-bonded to the electrodes provided on the piezoelectric material.

Subsequently, poling was performed on the piezoelectric material. In the poling, the elastic body was grounded, and the external electrodes connected to a power source were brought into contact with the first electrode and the second electrode, respectively. Although the FPC has already been connected to the first electrode and the second electrode, the electrodes are not entirely covered with the FPC, and an external electrode for poling is brought into contact with exposed portions of the electrodes. Next, after heating to T3 = 100°C, an electric field equivalent to 2 kV/mm was applied for 30 minutes. Then, after cooling for 40 minutes to 40°C while applying the electric field, the voltage application was terminated. The vibrator obtained through the above-described steps was brought into pressure contact with a contact body (a slider) made of SUS420J2, so that a vibration actuator was produced.

(Example 3)

A green sheet of a piezoelectric material was formed by a sheet forming method using the raw material powder of Production Composition 1. A through hole having a diameter of 0.2 mm was formed in a region of the green sheet in which the fourth electrode was to be printed after firing and processing. After performing firing in a manner similar to that in Example 1, the diameter of the through hole became 0.18 mm. The obtained piezoelectric material was ground approximately uniformly so as to have a thickness of 0.35 mm and polished, and then, the piezoelectric material was processed into a rectangular shape having a size of 8.7 mm × 5.7 mm. The first to fourth electrodes illustrated in Fig. 4A and Fig. 4B were formed on the two surfaces of the shaped piezoelectric material. A silver electrode was provided at the inner wall of the through hole, and the third electrode and the fourth electrode were electrically connected to each other via the through hole. The subsequent steps were performed in a manner similar to that in Example 2, so that a vibration actuator was produced.

(Example 4 to Example 9)

A vibration actuator was produced by the same method as in Example 3 while the amount of the conductive particles added was within a range of 0.9 weight percent concentration to 5 weight percent concentration (equivalent to a volume fraction of 0.4% to 2.0% of the conductive particles in the adhesive).

(Example 10 to Example 12)

A vibration actuator was produced by the method described in Example 3 by using a conductive bonding portion including conductive particles whose diameter was within a range of 2 microns to 5 microns. In this case, the amount of the conductive particles added (the weight percent concentration of the conductive particles) was varied in such a manner that the volume fraction of the conductive particles in the conductive bonding portion became 0.8%.

(Example 13 and Example 14)

A vibration actuator was produced by the method described in Example 3 by using a conductive bonding portion containing conductive particles whose metal material portions (shells) serving as their surfaces are formed of a Au/Ni multilayer film or conductive particles whose metal material portions (shells) serving as their surfaces are made of Ag.

(Example 15 to Example 18)

A vibration actuator was produced by using a conductive bonding portion including an epoxy adhesive B or an epoxy adhesive C that has a glass transition point different from that of an epoxy adhesive A included in the conductive bonding portion used in Examples 1 to 14. The process temperatures T1 to T3 were varied as shown in Table 1 while the same conductive particles as in Example 2 were used. In all of Examples 15 to 18, T1 was higher than T3, and T2 was higher than T3. In addition, T3 was lower than the glass transition temperature of the employed adhesive by more than 20°C. In Example 16, an epoxy adhesive D was used instead of an ACP for bonding the power supply member.

(Evaluation Manufacturing Method for Vibration Actuator and Evaluation)

In each of Examples and Comparative Examples, ten vibration actuators were produced, and a driving test was performed by applying an alternating-current voltage having an amplitude of 130 Vpp to each of the first and second electrodes. In this case, the phase difference between the voltage applied to the first electrode and the voltage applied to the second electrode was set to -90° and 90°.
When the frequency of the alternating-current voltage is swept from a frequency that is higher than both the resonant frequency of the vibration mode A and the resonant frequency of the vibration mode B toward the resonant frequency, the contact body is driven in a direction according to the phase difference of the alternating-current voltages and stops after reaching the maximum speed. For the sake of convenience, a traveling direction when the phase difference is -90° and a traveling direction when the phase difference is 90° will be respectively referred to as a reverse movement direction and a forward movement direction. The maximum speed of the vibrator and the frequency at which the vibrator reached the maximum speed were measured by using a sensor. The power at a certain rated speed lower than the maximum speed (a rated power) was calculated from the current flowing through a driving circuit.
There are standards corresponding to product specifications for maximum speed and rated power, and regarding the vibration actuators whose initial characteristics satisfied the standards, their durabilities were evaluated by causing them to continuously reciprocate. Table 1 also shows the percentage of non-defective products that satisfy the following conditions among the ten vibration actuators produced in each of Examples and Comparative Examples.

(1) Be driven at a maximum speed equal to or higher than a standard (with a specified lower limit) in both forward and reverse movements at a maximum speed equal to or greater than a standard
(2) Be driven at a rated power equal to or lower than a standard (with a specified upper limit) in both forward and reverse movements
(3) Satisfy (1) and (2) even after the durability test

The above conditions are not satisfied primarily due to the following reasons.

(1) Insufficient piezoelectric performance due to a failure in poling of the piezoelectric material
(2) Vibration absorption of a conductive bonding layer, and vibration of the piezoelectric material cannot be efficiently transmitted to the contact body
(3) Separation of the elastic body and the piezoelectric material occurs during the durability test

The vibration actuators produced in Examples 1 to 18 were evaluated according to the above conditions (1) to (3), all 10 out of 10 vibration actuators were non-defective. Next, evaluation results of the vibration actuators of Comparative Examples will be described.

[Table 1]

Table 1

| | Piezoelectric Material | | | | | Process Temperature | | | Non-Conductive Adhesive | | | Conductive Particle | | | | | Vibration Plate | Adhesive for Power Supply Member | Non-Defective Rate |
|---|---|---|---|---|---|---|---|---|---|---|---|---|---|---|---|---|---|---|---|
| | Shape | First Electrode | Second Electrode | Third Electrode | Fourth Electrode | T1 (°C) | T2 (°C) | T3 (°C) | Material | Tg (°C) | Specific Gravity (g/cm$^3$) | Material | Particle Diameter (μm) | Specific Gravity (g/cm$^3$) | Added Amount (wt%) | Volume Fraction in Adhesive (%) | Composition | | |
| Example 1 | Annular Shape | ○ | ○ | x | x | 160 | 140 | 100 | | | | Ni-Coated Resin Ball | 2.5 | 2.9 | 2 | 0.8 | SUS420J2 | ACP | 10/10 |
| Example 2 | Rectangular Shape | ○ | ○ | ○ | x | 160 | 140 | 100 | | | | Ni-Coated Resin Ball | 2.5 | 2.9 | 2 | 0.8 | SUS420J2 | ACP | 10/10 |
| Example 3 | Rectangular Shape | ○ | ○ | ○ | ○ | 160 | 140 | 100 | | | | Ni-Coated Resin Ball | 2.5 | 2.9 | 2 | 0.8 | SUS420J2 | ACP | 10/10 |
| Example 4 | Rectangular Shape | ○ | ○ | ○ | ○ | 160 | 140 | 100 | | | | Ni-Coated Resin Ball | 2.5 | 2.9 | 0.9 | 0.4 | SUS420J2 | ACP | 10/10 |
| Example 5 | Rectangular Shape | ○ | ○ | ○ | ○ | 160 | 140 | 100 | | | | Ni-Coated Resin Ball | 2.5 | 2.9 | 1 | 0.4 | SUS420J2 | ACP | 10/10 |
| Example 6 | Rectangular Shape | ○ | ○ | ○ | ○ | 160 | 140 | 100 | | | | Ni-Coated Resin Ball | 2.5 | 2.9 | 1.5 | 0.6 | SUS420J2 | ACP | 10/10 |

| | Piezoelectric Material | | | | | Process Temperature | | | Non-Conductive Adhesive | | | Conductive Particle | | | | | Vibration Plate | Adhesive for Power Supply Member | Non-Defective Rate |
|---|---|---|---|---|---|---|---|---|---|---|---|---|---|---|---|---|---|---|---|
| | Shape | First Electrode | Second Electrode | Third Electrode | Fourth Electrode | T1 (°C) | T2 (°C) | T3 (°C) | Material | Tg (°C) | Specific Gravity (g/cm³) | Material | Particle Diameter (μm) | Specific Gravity (g/cm³) | Added Amount (wt%) | Volume Fraction in Adhesive (%) | Composition | | |
| Example 7 | Rectangular Shape | ○ | ○ | ○ | ○ | 160 | 140 | 100 | | | | Ni-Coated Resin Ball | 2.5 | 2.9 | 2 | 0.8 | SUS420J2 | ACP | 10/10 |
| Example 8 | Rectangular Shape | ○ | ○ | ○ | ○ | 160 | 140 | 100 | | | | Ni-Coated Resin Ball | 2.5 | 2.9 | 2.5 | 1.0 | SUS420J2 | ACP | 10/10 |
| Example 9 | Rectangular Shape | ○ | ○ | ○ | ○ | 160 | 140 | 100 | | | | Ni-Coated Resin Ball | 2.5 | 2.9 | 5 | 2.0 | SUS420J2 | ACP | 10/10 |
| Comparative Example 1 | Rectangular Shape | ○ | ○ | ○ | ○ | 160 | 140 | 100 | Epoxy Adhesive A | 141 | | Ni-Coated Resin Ball | 2.5 | 2.9 | 0.5 | 0.2 | SUS420J2 | ACP | 8/10 |
| Comparative Example 2 | Rectangular Shape | ○ | ○ | ○ | ○ | 160 | 140 | 100 | | | | Ni-Coated Resin Ball | 2.5 | 2.9 | 10 | 4.4 | SUS420J2 | ACP | 6/10 |
| Example 10 | Rectangular Shape | ○ | ○ | ○ | ○ | 160 | 140 | 100 | | | | Ni-Coated Resin Ball | 2 | 3.3 | 2.3 | 0.8 | SUS420J2 | ACP | 10/10 |

18

EP 4 333 087 A1

(continued)

| | Piezoelectric Material | | | | | Process Temperature | | | Non-Conductive Adhesive | | | Conductive Particle | | | | | Vibration Plate | Adhesive for Power Supply Member | Non-Defective Rate |
| | Shape | First Electrode | Second Electrode | Third Electrode | Fourth Electrode | T1 (°C) | T2 (°C) | T3 (°C) | Material | Tg (°C) | Specific Gravity (g/cm³) | Material | Particle Diameter (µm) | Specific Gravity (g/cm³) | Added Amount (wt%) | Volume Fraction in Adhesive (%) | Composition | | |
|---|---|---|---|---|---|---|---|---|---|---|---|---|---|---|---|---|---|---|---|
| Example 11 | Rectangular Shape | ○ | ○ | ○ | ○ | 160 | 140 | 100 | | | | Ni-Coated Resin Ball | 3 | 2.6 | 1.8 | 0.8 | SUS420J2 | ACP | 10/10 |
| Example 12 | Rectangular Shape | ○ | ○ | ○ | ○ | 160 | 140 | 100 | | | | Ni-Coated Resin Ball | 5 | 2 | 1.4 | 0.8 | SUS420J2 | ACP | 10/10 |
| Example 13 | Rectangular Shape | ○ | ○ | ○ | ○ | 160 | 140 | 100 | | | 1.2 | Au/Ni-Coated Resin Ball | 2.5 | 3 | 2 | 0.8 | SUS420J2 | ACP | 10/10 |
| Example 14 | Rectangular Shape | ○ | ○ | ○ | ○ | 160 | 140 | 100 | | | | Ag-Coated Resin Ball | 2.5 | 3 | 2 | 1.0 | SUS420J2 | ACP | 10/10 |
| Comparative Example 3 | Rectangular Shape | ○ | ○ | ○ | ○ | 160 | 140 | 100 | | | | Ni-Coated Resin Ball | 10 | 16 | 1.3 | 1.0 | SUS420J2 | ACP | 0/10 |
| Comparative Example 4 | Rectangular Shape | ○ | ○ | ○ | ○ | 160 | 140 | 100 | | | | Ni-Coated Resin Ball | 10 | 4 | 1.3 | 1.0 | SUS420J2 | ACP | 0/10 |

| | Piezoelectric Material | | | | | Process Temperature | | | Non-Conductive Adhesive | | | Conductive Particle | | | | | Vibration Plate | Adhesive for Power Supply Member | Non-Defective Rate |
|---|---|---|---|---|---|---|---|---|---|---|---|---|---|---|---|---|---|---|---|
| | Shape | First Electrode | Second Electrode | Third Electrode | Fourth Electrode | T1 (°C) | T2 (°C) | T3 (°C) | Material | Tg (°C) | Specific Gravity (g/cm$^3$) | Material | Particle Diameter (μm) | Specific Gravity (g/cm$^3$) | Added Amount (wt%) | Volume Fraction in Adhesive (%) | Composition | | |
| Comparative Example 5 | Rectangular Shape | ○ | ○ | ○ | ○ | 160 | 140 | 100 | | | | Ni-Coated Resin Ball | 2.5 | 8.9 | 6 | 0.9 | SUS420J2 | ACP | 6/10 |
| Comparative Example 6 | Rectangular Shape | ○ | ○ | ○ | ○ | 160 | 140 | 100 | | | | None | - | - | 0 | 00 | SUS420J2 | ACP | 6/10 |
| Example 15 | Rectangular Shape | ○ | ○ | ○ | ○ | 100 | 140 | 80 | Epoxy Adhesive B | 104 | | Au/Ni-Coated Resin Ball | 2.5 | 2.9 | 2 | 0.8 | SUS420J2 | ACP | 10/10 |
| Example 16 | Rectangular Shape | ○ | ○ | ○ | ○ | 80 | 78 | 75 | | | | Au/Ni-Coated Resin Ball | 2.5 | 2.6 | 2 | 0.8 | SUS420J2 | Epoxy Adhesive D | 10/10 |
| Example 17 | Rectangular Shape | ○ | ○ | ○ | ○ | 120 | 140 | 100 | Epoxy Adhesive C | 120 | | Au/Ni-Coated Resin Ball | 2.5 | 2.9 | 2 | 0.8 | SUS420J2 | ACP | 10/10 |
| Example 18 | Rectangular Shape | ○ | ○ | ○ | ○ | 150 | 140 | 100 | | | | Au/Ni-Coated Resin Ball | 2.5 | 2.9 | 2 | 0.8 | SUS420J2 | ACP | 10/10 |
| Comparative Example 7 | Rectangular Shape | ○ | ○ | ○ | ○ | 40 | 40 | 100 | | | | Au/Ni-Coated Resin Ball | 2.5 | 2.9 | 2 | 0.8 | SUS420J2 | Epoxy Adhesive C | 0/10 |

EP 4 333 087 A1

[Table 2]

Table 2

| | x | y | a | Mn Concentration (parts by weight) | Bi Concentration (parts by weight) | Curie Temperature (°C) |
|---|---|---|---|---|---|---|
| Production Composition 1 | 0.020 | 0.020 | 1.002 | 0.10 | 0.00 | 124 |
| Production Composition 2 | 0.050 | 0.050 | 1.003 | 0.10 | 0.00 | 115 |
| Production Composition 3 | 0.095 | 0.030 | 1.002 | 0.08 | 0.00 | 120 |
| Production Composition 4 | 0.095 | 0.060 | 1.001 | 0.08 | 0.00 | 110 |
| Production Composition 5 | 0.095 | 0.095 | 1.002 | 0.06 | 0.00 | 85 |
| Production Composition 6 | 0.110 | 0.075 | 0.9994 | 0.240 | 0.170 | 106 |
| Production Composition 7 | 0.110 | 0.075 | 0.9994 | 0.240 | 0.170 | 106 |
| Production Composition 8 | 0.110 | 0.075 | 0.9994 | 0.240 | 0.340 | 106 |
| Production Composition 9 | 0.110 | 0.075 | 0.9969 | 0.240 | 0.510 | 106 |
| Production Composition 10 | 0.110 | 0.075 | 0.9994 | 0.040 | 0.850 | 106 |
| Production Composition 11 | 0.120 | 0.080 | 0.9994 | 0.240 | 0.170 | 104 |
| Production Composition 12 | 0.120 | 0.080 | 0.9994 | 0.240 | 0.340 | 104 |
| Production Composition 13 | 0.125 | 0.020 | 1.003 | 0.08 | 0.00 | 125 |
| Production Composition 14 | 0.125 | 0.050 | 1.001 | 0.06 | 0.00 | 114 |
| Production Composition 15 | 0.125 | 0.055 | 1.000 | 0.06 | 0.00 | 112 |
| Production Composition 16 | 0.125 | 0.090 | 1.000 | 0.06 | 0.00 | 88 |
| Production Composition 17 | 0.130 | 0.075 | 0.9994 | 0.240 | 0.170 | 106 |
| Production Composition 18 | 0.140 | 0.075 | 1.003 | 0.02 | 0.00 | 100 |
| Production Composition 19 | 0.140 | 0.075 | 1.000 | 0.02 | 0.00 | 100 |
| Production Composition 20 | 0.140 | 0.075 | 1.003 | 0.07 | 0.00 | 100 |

(continued)

| | x | y | a | Mn Concentration (parts by weight) | Bi Concentration (parts by weight) | Curie Temperature (°C) |
|---|---|---|---|---|---|---|
| Production Composition 21 | 0.140 | 0.075 | 1.000 | 0.07 | 0.00 | 100 |
| Production Composition 22 | 0.140 | 0.075 | 1.001 | 0.08 | 0.00 | 100 |
| Production Composition 23 | 0.140 | 0.078 | 0.9955 | 0.160 | 0.181 | 105 |
| Production Composition 24 | 0.140 | 0.075 | 1.0004 | 0.160 | 0.094 | 106 |
| Production Composition 25 | 0.140 | 0.075 | 1.0004 | 0.160 | 0.094 | 106 |
| Production Composition 26 | 0.140 | 0.075 | 1.0004 | 0.160 | 0.094 | 106 |
| Production Composition 27 | 0.140 | 0.075 | 1.0004 | 0.160 | 0.094 | 106 |
| Production Composition 28 | 0.140 | 0.075 | 1.0004 | 0.160 | 0.094 | 106 |
| Production Composition 29 | 0.140 | 0.075 | 1.0004 | 0.160 | 0.189 | 106 |
| Production Composition 30 | 0.140 | 0.075 | 1.0004 | 0.160 | 0.239 | 106 |
| Production Composition 31 | 0.140 | 0.075 | 1.0004 | 0.160 | 0.189 | 106 |
| Production Composition 32 | 0.140 | 0.075 | 1.0004 | 0.160 | 0.189 | 102 |
| Production Composition 33 | 0.140 | 0.075 | 1.0004 | 0.160 | 0.189 | 106 |
| Production Composition 34 | 0.140 | 0.085 | 1.0004 | 0.160 | 0.539 | 106 |
| Production Composition 35 | 0.140 | 0.080 | 1.0004 | 0.140 | 0.189 | 104 |
| Production Composition 36 | 0.140 | 0.080 | 1.0004 | 0.140 | 0.289 | 104 |
| Production Composition 37 | 0.140 | 0.080 | 1.0004 | 0.140 | 0.339 | 104 |
| Production Composition 38 | 0.140 | 0.075 | 1.0004 | 0.160 | 0.094 | 106 |
| Production Composition 39 | 0.155 | 0.020 | 1.005 | 0.15 | 0.00 | 123 |
| Production Composition 40 | 0.155 | 0.035 | 1.006 | 0.18 | 0.00 | 118 |
| Production Composition 41 | 0.155 | 0.041 | 1.004 | 0.18 | 0.00 | 117 |

(continued)

| | x | y | a | Mn Concentration (parts by weight) | Bi Concentration (parts by weight) | Curie Temperature (°C) |
|---|---|---|---|---|---|---|
| Production Composition 42 | 0.155 | 0.065 | 1.000 | 0.02 | 0.00 | 107 |
| Production Composition 43 | 0.155 | 0.065 | 1.001 | 0.06 | 0.00 | 106 |
| Production Composition 44 | 0.155 | 0.065 | 1.004 | 0.06 | 0.00 | 106 |
| Production Composition 45 | 0.155 | 0.065 | 1.001 | 0.10 | 0.00 | 106 |
| Production Composition 46 | 0.155 | 0.065 | 1.005 | 0.10 | 0.00 | 106 |
| Production Composition 47 | 0.155 | 0.069 | 1.004 | 0.18 | 0.00 | 102 |
| Production Composition 48 | 0.155 | 0.078 | 0.9994 | 0.240 | 0.170 | 105 |
| Production Composition 49 | 0.160 | 0.059 | 1.009 | 0.40 | 0.00 | 108 |
| Production Composition 50 | 0.160 | 0.078 | 1.0042 | 0.360 | 0.170 | 105 |

[Table 3]

| Table 2 Continued | | | | | | |
|---|---|---|---|---|---|---|
| | x | y | a | Mn Concentration (parts by weight) | Bi Concentration (parts by weight) | Curie Temperature (°C) |
| Production Composition 51 | 0.160 | 0.075 | 0.9971 | 0.180 | 0.170 | 106 |
| Production Composition 52 | 0.160 | 0.085 | 0.9971 | 0.180 | 0.170 | 102 |
| Production Composition 53 | 0.170 | 0.075 | 0.9971 | 0.180 | 0.170 | 106 |
| Production Composition 54 | 0.170 | 0.075 | 0.9998 | 0.140 | 0.189 | 106 |
| Production Composition 55 | 0.170 | 0.085 | 1.0010 | 0.120 | 0.189 | 104 |
| Production Composition 56 | 0.170 | 0.075 | 0.9971 | 0.180 | 0.170 | 106 |
| Production Composition 57 | 0.170 | 0.085 | 0.9971 | 0.180 | 0.170 | 102 |
| Production Composition 58 | 0.170 | 0.075 | 1.0042 | 0.360 | 0.170 | 106 |
| Production Composition 59 | 0.175 | 0.030 | 1.004 | 0.15 | 0.00 | 121 |

(continued)

| Table 2 Continued | | | | | | |
|---|---|---|---|---|---|---|
| | x | y | a | Mn Concentration (parts by weight) | Bi Concentration (parts by weight) | Curie Temperature (°C) |
| Production Composition 60 | 0.175 | 0.055 | 1.004 | 0.06 | 0.00 | 112 |
| Production Composition 61 | 0.175 | 0.090 | 1.007 | 0.10 | 0.00 | 88 |
| Production Composition 62 | 0.187 | 0.060 | 1.001 | 0.12 | 0.00 | 106 |
| Production Composition 63 | 0.187 | 0.060 | 1.007 | 0.18 | 0.00 | 106 |
| Production Composition 64 | 0.187 | 0.060 | 1.003 | 0.18 | 0.00 | 106 |
| Production Composition 65 | 0.187 | 0.060 | 1.009 | 0.24 | 0.00 | 106 |
| Production Composition 66 | 0.187 | 0.060 | 1.003 | 0.24 | 0.00 | 106 |
| Production Composition 67 | 0.187 | 0.060 | 1.008 | 0.30 | 0.00 | 106 |
| Production Composition 68 | 0.187 | 0.060 | 1.010 | 0.40 | 0.00 | 106 |
| Production Composition 69 | 0.187 | 0.079 | 0.9994 | 0.240 | 0.170 | 104 |
| Production Composition 70 | 0.187 | 0.077 | 0.9994 | 0.240 | 0.170 | 105 |
| Production Composition 71 | 0.200 | 0.035 | 1.006 | 0.20 | 0.00 | 118 |
| Production Composition 72 | 0.200 | 0.055 | 1.005 | 0.22 | 0.00 | 112 |
| Production Composition 73 | 0.200 | 0.070 | 1.007 | 0.24 | 0.00 | 102 |
| Production Composition 74 | 0.200 | 0.090 | 1.006 | 0.26 | 0.00 | 90 |
| Production Composition 75 | 0.200 | 0.075 | 0.9994 | 0.240 | 0.170 | 106 |
| Production Composition 76 | 0.220 | 0.082 | 0.9994 | 0.240 | 0.170 | 103 |
| Production Composition 77 | 0.220 | 0.030 | 1.005 | 0.22 | 0.00 | 120 |
| Production Composition 78 | 0.220 | 0.065 | 1.005 | 0.15 | 0.00 | 105 |
| Production Composition 79 | 0.220 | 0.065 | 1.002 | 0.15 | 0.00 | 105 |
| Production Composition 80 | 0.220 | 0.065 | 1.007 | 0.20 | 0.00 | 105 |

(continued)

| Table 2 Continued | | | | | | |
|---|---|---|---|---|---|---|
| | x | y | a | Mn Concentration (parts by weight) | Bi Concentration (parts by weight) | Curie Temperature (°C) |
| Production Composition 81 | 0.220 | 0.065 | 1.006 | 0.20 | 0.00 | 106 |
| Production Composition 82 | 0.220 | 0.065 | 1.005 | 0.25 | 0.00 | 105 |
| Production Composition 83 | 0.220 | 0.080 | 1.006 | 0.28 | 0.00 | 92 |
| Production Composition 84 | 0.260 | 0.020 | 1.006 | 0.22 | 0.00 | 124 |
| Production Composition 85 | 0.260 | 0.045 | 1.004 | 0.24 | 0.00 | 115 |
| Production Composition 86 | 0.260 | 0.065 | 1.004 | 0.26 | 0.00 | 106 |
| Production Composition 87 | 0.260 | 0.070 | 1.005 | 0.28 | 0.00 | 100 |
| Production Composition 88 | 0.260 | 0.077 | 0.9994 | 0.240 | 0.170 | 105 |
| Production Composition 89 | 0.260 | 0.082 | 0.9994 | 0.240 | 0.170 | 103 |
| Production Composition 90 | 0.260 | 0.076 | 0.9994 | 0.240 | 0.170 | 106 |
| Production Composition 91 | 0.280 | 0.075 | 0.9994 | 0.240 | 0.170 | 106 |
| Production Composition 92 | 0.300 | 0.020 | 1.004 | 0.26 | 0.00 | 126 |
| Production Composition 93 | 0.300 | 0.041 | 1.007 | 0.26 | 0.00 | 118 |
| Production Composition 94 | 0.300 | 0.050 | 1.006 | 0.28 | 0.00 | 116 |
| Production Composition 95 | 0.300 | 0.069 | 1.009 | 0.30 | 0.00 | 100 |
| Production Composition 96 | 0.300 | 0.095 | 1.008 | 0.30 | 0.00 | 88 |
| Production Composition 97 | 0.300 | 0.075 | 0.9994 | 0.240 | 0.170 | 106 |
| Production Composition 98 | 0.300 | 0.085 | 0.9994 | 0.120 | 0.170 | 102 |
| Production Composition 99 | 0.300 | 0.085 | 0.9994 | 0.240 | 0.170 | 102 |
| Production Composition 100 | 0.300 | 0.082 | 0.9994 | 0.240 | 0.170 | 103 |
| Production Composition 101 | 0.300 | 0.076 | 0.9994 | 0.240 | 0.170 | 106 |

(Comparative Example 1)

A vibrator was produced by a method similar to that in Example 3 with a significantly small amount of the conductive particles included in the conductive bonding portion, which was 0.5% by weight (the volume fraction was 0.2%). Since the amount of the conductive particles was small, the conductive particles were crushed when the elastic body and the piezoelectric material were bonded to each other. As a result, the thickness of the conductive bonding portion became significantly small, and the maximum speed after the durability test did not satisfy the standard.

(Comparative Example 2)

A vibrator was produced by a method similar to that in Example 3 with a significantly large amount of the conductive particles included in the conductive bonding portion, which was 10% by weight (the volume fraction was 4.4%). In the vibration actuator using this vibrator, the bonding strength between the elastic body and the piezoelectric element was not sufficient, and separation of the elastic body sometimes occurred during the durability test.

(Comparative Example 3)

A vibrator was produced by using a conductive bonding portion including conductive particles each having a diameter of 10 microns. The thickness of a layer of each conductive particle, which is the outermost surface, is similar to that in Example 3. In this case, since the thickness of a metal coating portion of each conductive particle was set to be similar to that of each particle used in Example 3, the ratio of a resin portion at the core was increased, and the specific gravity is less than 2 g/cm$^3$.

(Comparative Example 4)

A vibrator was produced by using a conductive bonding portion including conductive particles each having a diameter of 10 microns. The thickness of a layer of each conductive particle, which is the outermost surface, is similar to that in Example 3. The difference from Comparative Example 3 is that the thickness of the Ni coating layer at the surface is increased and that the specific gravity is 4 g/cm$^3$. The vibration actuator using the vibrator of Comparative Example 3 and the vibration actuator using the vibrator of Comparative Example 4 both had poor driving efficiency, and their driving performances did not satisfy the specifications.

(Comparative Example 5)

A vibrator was produced by using a conductive bonding portion including Ni balls (without a resin core material) having a diameter of 2.5 microns as conductive particles. Comparative Example 5 is similar to Example 3 except for the material of the conductive particles. Precipitation of the conductive particles in the conductive bonding portion occurred, and the conductive particle concentration became non-uniform. In the vibration actuator using this vibrator, the bonding strength between the elastic body and the piezoelectric element was not sufficient, and separation of the elastic body sometimes occurred during the durability test.

(Comparative Example 6)

A vibrator was produced by using, instead of a conductive bonding portion, an adhesive containing no conductive particles. Comparative Example 6 is similar to Example 3 except that no conductive particles are contained. In the vibration actuator using this vibrator, the bonding strength between the elastic body and the piezoelectric element was not sufficient, and separation of the elastic body sometimes occurred during the durability test.

(Comparative Example 7)

In contrast to Example 17, a conductive bonding portion was cured at a temperature lower than T3 by increasing the pressure bonding time (T3>T1), and the power supply member was also bonded at a low temperature with the epoxy adhesive C used for bonding the elastic body, so that the vibration actuator of the present invention (T3>T2) was produced. The conductive bonding portion was soft even though it was cured, and the vibration actuator using the vibrator of Comparative Example 7 had poor driving efficiency and its driving performance did not satisfy the specifications.

(Example 19)

An optical device illustrated in Fig. 5 was produced by mechanically connecting the vibration actuator produced in Example 3 and an optical member to each other. The vibration actuator and the optical member connected to the vibration actuator were able to be precisely driven to target positions by controlling, on the basis of positional information given to an encoder including a sensor and a scale, an alternating-current voltage applied to the piezoelectric material. In this optical device, an optical lens is connected to the vibration actuator, and it was confirmed that the optical device had an autofocus function.

Although Production Composition 1 has been described above as an example, it was confirmed that the vibration actuator of the present invention was able to be produced with a high yield similar to that in Example 3 also in Production Compositions 2 to 101. The vibration actuator of the present invention that includes a vibrator in which an electrode, a piezoelectric material, and an elastic body are sequentially arranged and a contact body that is in contact with the elastic body and in which the elastic body and the piezoelectric material are bonded to each other by a conductive bonding portion can be manufactured with a favorable yield.

The vibration actuator of the present invention can be used for various purposes such as driving a lens or an imaging element of an imaging device (an optical device), driving a photoconductor drum of a copying machine so as to cause the photoconductor drum to rotate, and driving a stage. Although one vibration actuator has been described in the present specification, a plurality of vibration actuators may be arranged in an annular shape so as to drive a ring-shaped contact body such that the ring-shaped contact body rotates.

The present invention is not limited to the above-described embodiments, and various changes and modifications can be made without departing from the spirit and scope of the present invention. Accordingly, in order to make the scope of the present invention public, the following claims are appended.

This application claims the benefit of Japanese Patent Application No. 2021-074969 filed April 27, 2021, which is hereby incorporated by reference herein in its entirety.

**Claims**

1. A vibration actuator comprising:

   a vibrator in which an electrode, a rectangular piezoelectric material, and an elastic body are sequentially arranged; and
   a contact body that is disposed so as to be in contact with the elastic body and so as to be movable relative to the vibrator,
   wherein the elastic body and the piezoelectric material are bonded to each other by a conductive bonding portion.

2. The vibration actuator according to Claim 1,

   wherein the electrode includes a first electrode and a second electrode that are adjacent to each other,
   wherein, when a region of the piezoelectric material in which the first electrode is disposed and a region of the piezoelectric material in which the second electrode is disposed are respectively defined as a first region and a second region, the vibrator forms

      a first bending vibration mode in which the first region and the second region extend or contract together and
      a second bending vibration mode in which the second region contracts when the first region extends and in which the second region extends when the first region contracts.

3. The vibration actuator according to Claim 2,
   wherein the elastic body includes a rectangular portion, and the vibrator is held at four corners of the rectangular portion by a vibrator holding member.

4. The vibration actuator according to Claim 3,
   wherein the elastic body includes a support portion that protrudes from an end portion of the rectangular portion.

5. The vibration actuator according to any one of Claims 2 to 4 comprising:
   a third electrode that sandwiches the piezoelectric material together with the first and second electrodes.

6. The vibration actuator according to Claim 5, further comprising:

a fourth electrode that is adjacent to the first and second electrodes and that is electrically connected to the third electrode.

7. The vibration actuator according to any one of Claims 1 to 6,
   wherein an average thickness of the conductive bonding portion is 1.5 microns or more and 7 microns or less.

8. The vibration actuator according to any one of Claims 1 to 7,
   wherein the conductive bonding portion includes conductive particles whose average particle diameter is 2 microns or more and 5 microns or less with a volume fraction of 0.4% or more and 2% or less.

9. The vibration actuator according to Claim 8,
   wherein a specific gravity of the conductive particles is 2.0 g/cm$^3$ or more and 4.0 g/cm$^3$ or less.

10. The vibration actuator according to any one of Claims 1 to 9,
    wherein the conductive bonding portion is an anisotropic conductive material.

11. The vibration actuator according to any one of Claims 1 to 10,
    wherein a lead content of the piezoelectric material is less than 1,000 ppm.

12. The vibration actuator according to Claim 11,
    wherein the piezoelectric material contains a barium titanate-based material.

13. The vibration actuator according to Claim 12,
    wherein the piezoelectric material contains barium calcium zirconate titanate.

14. The vibration actuator according to any one of Claims 1 to 13 comprising:
    a power supply member that is bonded to a piezoelectric element including the piezoelectric material and the electrode.

15. The vibration actuator according to any one of Claims 1 to 14,
    wherein the elastic body is made of martensitic stainless steel.

16. The vibration actuator according to any one of Claims 1 to 15,
    wherein a plurality of the vibrators are in contact with the single common contact body, and the contact body is caused by vibrations of the plurality of vibrators to perform relative movement.

17. An electronic device comprising:

    a member; and
    the vibration actuator according to any one of Claims 1 to 16 that is provided at the member.

18. An optical device comprising:

    the vibration actuator according to any one of Claims 1 to 16 that is provided at a driving unit,
    wherein the optical device further comprises at least one of an optical element and an imaging element.

19. A wire-driven actuator comprising:

    an elongated member;
    a wire inserted through the elongated member and fixed to a portion of the elongated member; and
    the vibration actuator according to any one of Claims 1 to 16 that drives the wire,
    wherein the elongated member is bent as a result of the wire being driven.

20. A method of manufacturing a vibrator comprising:

    a step of obtaining a piezoelectric element by providing an electrode at an unpolarized piezoelectric material;
    a step of bonding the piezoelectric element and an elastic body to each other at a temperature T1 with a conductive bonding portion interposed between the piezoelectric element and the elastic body;

a step of bonding the piezoelectric element and a power supply member to each other at a temperature T2; and
a step of performing poling at a temperature T3 by applying a voltage between the electrode and the elastic body, wherein the steps are sequentially performed, and the temperatures T1, T2, and T3 satisfy relationships of T1>T3 and T2>T3.

21. The method of manufacturing a vibrator according to Claim 20,
wherein, in the poling, an external electrode other than the power supply member is brought into contact with the electrode, and a voltage is applied between the external electrode and the elastic body.

22. The method of manufacturing a vibrator according to Claim 20 or 21,
wherein the elastic body is martensitic stainless steel.

23. A method of driving a vibration actuator,

wherein the vibration actuator includes

a vibrator in which an electrode, a piezoelectric material, and an elastic body are sequentially arranged, and
a contact body that is in contact with the elastic body,

wherein the elastic body and the piezoelectric material are bonded to each other by a conductive bonding portion, wherein the piezoelectric material includes

a first electrode provided in a first region,
a second electrode provided in a second region that is adjacent to the first region,
a third electrode that sandwiches the piezoelectric material together with the first and second electrodes, and
a fourth electrode provided in a third region and electrically connected to the third electrode, the third region being adjacent to the first and second regions, and

wherein a voltage is applied between the first electrode and the fourth electrode and between the second electrode and the fourth electrode.

FIG. 1A

FIG. 1B

FIG. 1C

# FIG. 1D

# FIG. 1E

# FIG. 1F

# FIG. 2A

MODE A

# FIG. 2B

MODE B

# FIG. 3A

101a  101b  102

# FIG. 3B

101c  102

# FIG. 4A

101a     101d     101b     102

# FIG. 4B

101c     102

# FIG. 5

POWER SUPPLY MEMBER 507

GUIDE MEMBER 504

SCREW 503

104 CONTACT BODY

110 VIBRATOR

501 HOLDING MEMBER

510 CONNECTING MEMBER

504 GUIDE MEMBER

509 SCALE

508 SENSOR

505 LENS HOLDING MEMBER

502 MOVABLE HOUSING

LENS 506

## INTERNATIONAL SEARCH REPORT

| | International application No. |
|---|---|
| | **PCT/JP2022/018116** |

**A.    CLASSIFICATION OF SUBJECT MATTER**

*H01L 41/257*(2013.01)i; *H02N 2/12*(2006.01)i
    FI:    H02N2/12; H01L41/257

According to International Patent Classification (IPC) or to both national classification and IPC

**B.    FIELDS SEARCHED**

Minimum documentation searched (classification system followed by classification symbols)

    H01L41/257; H02N2/12

Documentation searched other than minimum documentation to the extent that such documents are included in the fields searched

    Published examined utility model applications of Japan 1922-1996
    Published unexamined utility model applications of Japan 1971-2022
    Registered utility model specifications of Japan 1996-2022
    Published registered utility model applications of Japan 1994-2022

Electronic data base consulted during the international search (name of data base and, where practicable, search terms used)

**C.    DOCUMENTS CONSIDERED TO BE RELEVANT**

| Category* | Citation of document, with indication, where appropriate, of the relevant passages | Relevant to claim No. |
|---|---|---|
| X | JP 2019-140730 A (FDK CORP.) 22 August 2019 (2019-08-22) | 1 |
| | paragraphs [0013]-[0015], fig. 1, 2 | |
| Y | paragraphs [0013]-[0015], fig. 1, 2 | 1-23 |
| Y | JP 2017-184233 A (CANON INC.) 05 October 2017 (2017-10-05) | 1-23 |
| | paragraphs [0022]-[0048], [0085], [0132], fig. 2-7 | |
| Y | JP 2021-40374 A (CANON INC.) 11 March 2021 (2021-03-11) | 3-19 |
| | paragraph [0034], fig. 4, 5 | |
| Y | JP 2014-18027 A (CANON INC.) 30 January 2014 (2014-01-30) | 16-19 |
| | paragraphs [0015], [0016], fig. 1, 2 | |
| Y | JP 2018-140101 A (CANON INC.) 13 September 2018 (2018-09-13) | 19 |
| | paragraphs [0011]-[0015], fig. 1, 4 | |
| A | JP 6-121560 A (OLYMPUS OPTICAL CO., LTD.) 28 April 1994 (1994-04-28) | 1-23 |
| | paragraph [0020] | |

| ✓ Further documents are listed in the continuation of Box C. | ✓ See patent family annex. |
|---|---|

\*    Special categories of cited documents:
"A"    document defining the general state of the art which is not considered to be of particular relevance
"E"    earlier application or patent but published on or after the international filing date
"L"    document which may throw doubts on priority claim(s) or which is cited to establish the publication date of another citation or other special reason (as specified)
"O"    document referring to an oral disclosure, use, exhibition or other means
"P"    document published prior to the international filing date but later than the priority date claimed

"T"    later document published after the international filing date or priority date and not in conflict with the application but cited to understand the principle or theory underlying the invention
"X"    document of particular relevance; the claimed invention cannot be considered novel or cannot be considered to involve an inventive step when the document is taken alone
"Y"    document of particular relevance; the claimed invention cannot be considered to involve an inventive step when the document is combined with one or more other such documents, such combination being obvious to a person skilled in the art
"&"    document member of the same patent family

| Date of the actual completion of the international search | Date of mailing of the international search report |
|---|---|
| **09 June 2022** | **26 July 2022** |

| Name and mailing address of the ISA/JP | Authorized officer |
|---|---|
| **Japan Patent Office (ISA/JP)** **3-4-3 Kasumigaseki, Chiyoda-ku, Tokyo 100-8915** **Japan** | |
| | Telephone No. |

Form PCT/ISA/210 (second sheet) (January 2015)

**INTERNATIONAL SEARCH REPORT**

International application No.

**PCT/JP2022/018116**

| C. | DOCUMENTS CONSIDERED TO BE RELEVANT | |
|---|---|---|
| Category* | Citation of document, with indication, where appropriate, of the relevant passages | Relevant to claim No. |
| A | JP 2003-46158 A (KYOCERA CORP.) 14 February 2003 (2003-02-14)<br>paragraph [0029] | 1-23 |
| A | JP 2012-203085 A (NIKON CORP.) 22 October 2012 (2012-10-22)<br>paragraph [0019], fig. 2, 3 | 1-23 |

Form PCT/ISA/210 (second sheet) (January 2015)

**INTERNATIONAL SEARCH REPORT**
Information on patent family members

International application No.

**PCT/JP2022/018116**

| Patent document cited in search report | | | Publication date (day/month/year) | Patent family member(s) | | | Publication date (day/month/year) |
|---|---|---|---|---|---|---|---|
| JP | 2019-140730 | A | 22 August 2019 | (Family: none) | | | |
| JP | 2017-184233 | A | 05 October 2017 | US<br>paragraphs [0044]-[0074],<br>[0122], [0181], fig. 2-7<br>WO | 2019/0115853<br><br><br>2017/164413 | A1<br><br><br>A1 | |
| JP | 2021-40374 | A | 11 March 2021 | US<br>paragraph [0046], fig. 4, 5 | 2021/0067059 | A1 | |
| JP | 2014-18027 | A | 30 January 2014 | US<br>paragraphs [0032], [0033], fig.<br>1A-2 | 2014/0016014 | A1 | |
| JP | 2018-140101 | A | 13 September 2018 | US<br>paragraphs [0021]-[0026], fig.<br>1A, 4 | 2018/0242820 | A1 | |
| JP | 6-121560 | A | 28 April 1994 | (Family: none) | | | |
| JP | 2003-46158 | A | 14 February 2003 | (Family: none) | | | |
| JP | 2012-203085 | A | 22 October 2012 | (Family: none) | | | |

Form PCT/ISA/210 (patent family annex) (January 2015)

**EP 4 333 087 A1**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2017184233 A
- JP 2021074969 A